# EUROPEAN PATENT APPLICATION

(11) **EP 2 650 924 A1**
(43) Date of publication of application: **16.10.2013**
(21) Application number: 11846966.7
(22) Date of filing: 08.12.2011
(51) Int. Cl.: H01L 31/04

(54) **PHOTOELECTRIC CONVERSION ELEMENT AND SOLAR CELL COMPRISING SAME**

(30) Priority: 10.12.2010 JP 2010275874
(71) Applicant: FUJIFILM Corporation, Tokyo 106-8620 (JP)
(72) Inventor: KAWANO, Tetsuo, Ashigarakami-gun Kanagawa 258-8577 (JP); KAGA, Hiroshi, Ashigarakami-gun Kanagawa 258-8577 (JP)
(74) Representative: HOFFMANN EITLE
(86) International application number: PCT/JP2011/006873
(87) International publication number: WO 2012/077346

(57) **Abstract**

[Problems to be Solved]

To provide a photoelectric conversion device that includes a buffer layer capable of uniformly covering an under layer and has high in-plane uniformity of photoelectric conversion efficiency.

[Means for Solving the Problems]

The photoelectric conversion device of the present invention is a photoelectric conversion device 1 which includes a substrate (10) on which the following are layered in the order listed below: a lower electrode layer (20); a photoelectric conversion semiconductor layer (30) which includes, as a major component, at least one kind of compound semiconductor having a chalcopyrite structure formed of a group Ib element, a group IIIb element, and a group VIb element; a buffer layer (40); and a transparent conductive layer (50), in which a carbonyl ion (C) is provided on a surface (40ₛ) of the buffer layer (40) on the side of the transparent conductive layer (50) and the buffer layer (40) is a thin film layer having an average film thickness of 10nm to 70nm and includes a ternary compound of a cadmium-free metal, oxygen, and sulfur.

## Description

### Technical Field

The present invention relates to a photoelectric conversion device and a solar cell having the same.

### Background Art

Photoelectric conversion devices having a photoelectric conversion layer and electrodes in electrical communication with the layer are used in various applications including solar cells. Most of the conventional solar cells are Si-based cells that use bulk monocrystalline Si, polycrystalline Si, or thin film amorphous Si. Recently, however, research and development of compound semiconductor-based solar cells that do not depend on Si has been carried out. Two types of compound semiconductor-based solar cells are known, one of which is a bulk system, such as GaAs system and the like, and the other of which is a thin film system, such as CIS system formed of a group Ib element, a group IIIb element, and a group VIb element, CIGS, or the like. CI(G)S is a compound semiconductor represented by a general chemical formula, Cu_{1-z}In₁₋ₓGaₓSe₂-_{y}S_{y} (where, 0≤x≤1, 0≤y≤2, and 0≤z≤1), and the formula represents a CIS system when x=0 and a CIGS system when x>0. The CIS and CIGS are herein collectively represented as "CI(G)S".

In conventional thin film photoelectric conversion devices such as CI(G)S systems and the like, a CdS buffer layer is usually provided between a photoelectric conversion layer and a transparent conductive layer (transparent electrode). In such systems, the buffer layer is formed by CBD (Chemical Bath Deposition) process.

Rolls of the buffer layer may include (1) prevention of recombination of photogenerated carriers (2) band discontinuity alignment (3) lattice matching and (4) coverage of surface unevenness of the photoelectric conversion layer. It is considered that the CBD process, which is a liquid phase deposition process, is preferable for CI (G) S systems in order to satisfy, in particular, (4) above, as the surface unevenness of the photoelectric conversion layer is relatively large.

In the mean time, the study of Cd-free buffer layers is in progress in view of the environmental burden, and as a major component of Cd-free buffer layers, the use of zinc systems, such as ZnO systems, ZnS systems, and the like is also under study.

Patent Document 1 discloses a method of producing a Zn (0, OH, S) buffer layer using a reaction solution that includes a zinc-containing compound, a sulfur-containing compound, and an ammonium salt (claim 1). Patent Document 1 also describes that a reaction solution that includes 0.5mol/l or less of ammonia is preferably used (claim 2) . Patent Document 1 further describes that a reaction temperature of 10 to 100°C and a pH of 9.0 to 11.0 are preferable (claims 6 and 7).

Patent Document 2 discloses a method of producing a Zn (S, O) buffer layer using a reaction solution containing zinc acetate, thiourea, and ammonia (Example 3). In Example 3 of Patent Document 2, concentrations of the zinc acetate, thiourea, and ammonia are 0.025M, 0.375M, and 2.5M respectively.

Patent Document 3 discloses a method of producing a Zn(S, O, OH) buffer layer using a reaction solution which is a mixture of a solution provided by dissolving zinc salt in ammonia water or ammonium hydroxide water and an aqueous solution provided by dissolving sulfur-containing salt in purified water (claim 1). Patent Document 3 describes that the film forming is performed with a transparency level of the reaction solution within the range of 100% to 50% (claim 1). Patent Document 3 further describes that a reaction temperature of 80 to 90°C and a pH of 10.0 to 13.0 are preferable (claims 5 and 6).

Patent Document 4 discloses a method of producing a Zn(S, O) buffer layer by a roll-to-roll process using a reaction solution containing zinc acetate, thiourea, and ammonia (claim 2 and Example 2). In Example 2 of Patent Document 4, concentrations of the zinc acetate, thiourea, and ammonia are 0.025M, 0.375M, and 2.5M respectively.

Patent Document 5 discloses a method of producing a ZnS buffer layer using a reaction solution containing zinc sulfate, ammonia, and thiourea (claim 4).

Patent Document 6 discloses a method of producing a buffer layer which includes the steps of dissolving a 0.05 to 0.5 mol/l of zinc sulfate and a 0.2 to 1.5 mol/l of thiourea in distilled water at a temperature of 70 to 90°C, adding about 25% ammonia in the amount of 1/3 of the water, and after the solution becomes transparent, dipping the substrate in the solution for about 10 minutes to maintain the temperature substantially at constant during the time (claim 1).

Patent Document 7 discloses that, in a CIGS thin film solar cell, the buffer layer includes a cadmium-free metal component and oxygen with additional sulfur. The buffer layer of Patent Document 7 is defined to include a ternary compound of a metal component, oxygen, and sulfur, and the absorber layer includes an alkali metal adduct at a concentration of about 5 atom%.

Patent Document 8 discloses a method of forming a buffer layer by providing a nucleus, which is a particle of the same kind as or a different kind from that of the buffer layer, and forming the buffer layer with the nucleus as the starting point or the catalyst (claim 1). Further, ZnS is specifically cited as a major component of the particle serving as the nucleus and the buffer layer (claim 8). Patent Document 8 discloses that by growing a CBD film after forming a fine particle layer that functions as the nucleus of crystal growth, catalyst, or the like, the reaction speed of the CBD film forming process may be increased and a highly homogeneous buffer layer with comparatively less fine particle masses or cracks having gaps may be formed by controlling the crystal growth with the fine particle layer.

Non-Patent Document 1 and Non-Patent Document 2 describe a method of producing a ZnS thin film using a reaction solution containing zinc sulfate, thiourea, ammonia, and sodium citrate. In Non-Patent Documents 1 and 2, the film forming is performed at a reaction temperature of 60 to 80°C.

Non-Patent Document 3 describes a method of producing a ZnS thin film using a reaction solution containing zinc sulfate and thioacetamide. In Non-Patent Document 3, the film forming is performed at a reaction temperature of 95°C with a reaction time of 90 to 120 minutes.

Non-Patent Document 4 describes that the compositions of ZnSO₄, (NH₂)₂CS, and NH₄OH in the CBD reaction solution are 0.025-0.150, 0.2-0.5, and 1.0-7.0M respectively.

### [Prior Art Document]

### [Patent Document]

Patent Document 1: Japanese Unexamined Patent Publication No. 2000-332280.
Patent Document 2: Japanese Unexamined Patent Publication No. 2001-196611.
Patent Document 3: Japanese Unexamined Patent Publication No. 2002-343987.
Patent Document 4: Japanese Unexamined Patent Publication No. 2003-124487.
Patent Document 5: Japanese Unexamined Patent Publication No. 2002-118068.
Patent Document 6: PCT Japanese Publication No. 2008-510310.
Patent Document 7: DE Unexamined Patent Publication No. 4440878.
Patent Document 8: Japanese Unexamined Patent Publication No. 2007-242646.

### [Non-Patent Document]

Non-Patent Document 1: Literature, D. Johnston, I. Forbes, K.T. Ramakrishna Reddy, and R.W. Miles, Journal of Materials Science Letters 20, 921-923 (2001).
Non-Patent Document 2: Literature, D. Johnston, M.H. Carletto, K.T.R. Reddy, I. Forbes, and R.W. Miles, Thin Solid Films, 403-404, 102-106 (2002).
Non-Patent Document 3: Literature, Hyun Joo Lee and Soo Il Lee, Current Applied Physics, 7, 193-197 (2007).
Non-Patent Document 4: Literature, Larina, L., Shin, D.H., Tsvetkov, N., Ahn, B.T., Journal of the Electrochemical Society 156 (11), D469-D473 (2009).

### Disclosure of the Invention

As described above, it is difficult to form a buffer layer on a CI(G)S photoelectric conversion semiconductor layer having relatively large surface unevenness as a uniform film without any gap. A defect in the buffer layer, such as a gap or crack, may cause problems, such as degradation in the photoelectric conversion efficiency due to loss of buffering effects in the defective portion, a variation in the photoelectric conversion efficiency from cell to cell due to degraded in-plane homogeneity of photoelectric conversion efficiency, and the like.

As described in Patent Documents 1 to 8 and Non-Patent Documents 1 to 4, various types of Cd-free Zn buffer layers are proposed. It is known, however, that a Zn buffer layer have a great variation in photoelectric conversion efficiency in comparison with a Cd buffer layer and, in particular, the variation further becomes greater in the case where a flexible substrate is used. In the aforementioned documents, the photoelectric conversion efficiency and uniformity thereof are not evaluated or otherwise favorable photoelectric conversion characteristics are not obtained.

Further, in forming Zn buffer layers by CBD process, it is one of the problems to improve production costs by increasing the reaction speed. As described above, reaction speed improvement is attempted in Patent Document 8. As the reaction solution used in Patent Document 8, however, is highly alkaline, substrates which include metals easily soluble in an alkaline solvent, such as metals, including aluminum, capable of forming a complex ion with a hydroxide ion, cannot be used.

The present invention has been developed in view of the circumstances described above, and it is an object of the present invention to provide a photoelectric conversion device having a Cd-free buffer layer capable of uniformly covering an under layer and having high in-plane uniformity of photoelectric conversion efficiency.

It is a further object of the present invention to provide a photoelectric conversion device having a Zn buffer layer that can also be formed on a substrate which includes a metal easily soluble in an alkaline solvent and having high in-plane uniformity of photoelectric conversion efficiency.

A photoelectric conversion device of the present invention is a device, including a substrate on which the following are layered in the order listed below: a lower electrode layer; a photoelectric conversion semiconductor layer which includes, as a major component, at least one kind of compound semiconductor having a chalcopyrite structure formed of a group Ib element a group IIIB element, and a group VIb element; a buffer layer; and a transparent conductive layer, wherein:
a carbonyl ion is provided on a surface of the buffer layer on the side of the transparent conductive layer; and
the buffer layer is a thin film layer with an average film thickness of 10nm to 70nm and includes a ternary compound of a cadmium-free metal, oxygen, and sulfur, wherein the carbonyl ion is preferable to be adsorbed on the surface of the buffer layer.

The phrase "ternary compound of a cadmium-free metal, oxygen, and sulfur" as used herein refers to a ternary compound that includes at least an oxide of a cadmium-free metal and a sulfide of the cadmium-free metal. More specifically, it refers to a ternary compound which includes an oxide and a sulfide of a cadmium-free metal not less than 20 mol% with respect to the total number of moles of the oxide and sulfide respectively.

The term "average film thickness of the buffer layer" as used herein refers to an average value obtained by observing the cross-section of the buffer layer with a scanning electron microscope (SEM) and measuring film thicknesses at the total of 21 different points from SEM images of different visual fields.

The term "major component" as used herein refers to a component with a content of 80% by mass or more, unless otherwise specifically described.

In the photoelectric conversion device of the present invention, it is preferable that the carbonyl ion has a plurality of carbonyl groups and it is more preferable that the carbonyl ion is a citrate ion.

The cadmium-free metal is preferable to be at least one kind of metal (which may include an unavoidable impurity) selected from the group consisting of Zn, In, and Sn and is more preferable to be Zn.

Preferably, the photoelectric conversion device of the present invention includes, in the substrate, a metal capable of forming a complex ion with a hydroxide ion. As for such substrate, an anodized substrate selected from the group consisting of the following is preferably used:
an anodized substrate formed of an Al-based Al base with an Al₂O₃-based anodized film formed on at least one surface side;
an anodized substrate formed of a composite base of a Fe-based Fe material and an Al-based Al material attached to at least one surface side of the Fe material with an Al₂O₃-based anodized film formed on at least one surface side of the composite base; and
an anodized substrate formed of a base of a Fe-based Fe material and an Al-based Al film formed on at least one surface side of the Fe material with an Al₂O₃-based anodized film formed on at least one surface side of the base.

A solar cell of the present invention is a solar cell having the photoelectric conversion device of the present invention described above.

In the photoelectric conversion device of the present invention, a carbonyl ion is provided on a surface of the buffer layer on the side of the transparent conductive layer, and the buffer layer is a thin film layer with an average film thickness of 10nm to 70nm and includes a ternary compound of a cadmium-free metal, oxygen, and sulfur. According to such arrangement, the compactness of the buffer layer is increased by the presence of the carbonyl ion and the buffer layer may uniformly cover the under layer. Thus, according to the present invention, a photoelectric conversion device having high photoelectric conversion efficiency and high in-plane uniformity thereof may be provided.

Further, such buffer layer may be formed under moderate alkaline conditions, so that a base material which includes a metal easily soluble in an alkaline solvent, such as aluminum, maybe used as the substrate. Therefore, an embodiment having a substrate that includes a thin and highly flexible aluminum metal may provide a flexible photoelectric conversion device having high in-plane uniformity of photoelectric conversion efficiency.

### Brief Description of Drawings

Figure 1 is a schematic cross-sectional view of a photoelectric conversion device according to an embodiment of the present invention.
Figure 2 shows schematic cross-sections of anodized substrates to illustrate the structures thereof.
Figure 3 is a perspective view illustrating a method of manufacturing an anodized substrate.
Figure 4 is a SEM photograph of cross-section of a sample of Example 2.
Figure 5 illustrates IR spectra of buffer layer surfaces and CIGS surfaces prior to forming the buffer layers of Examples 2 and 4, and various kinds of raw powders.
Figure 6 illustrates the relationship between the characteristics of each photoelectric conversion device of Examples and Comparative Examples and the thickness of the buffer layer.

### Best Mode for Carrying Out the Invention

### [Photoelectric Conversion Device]

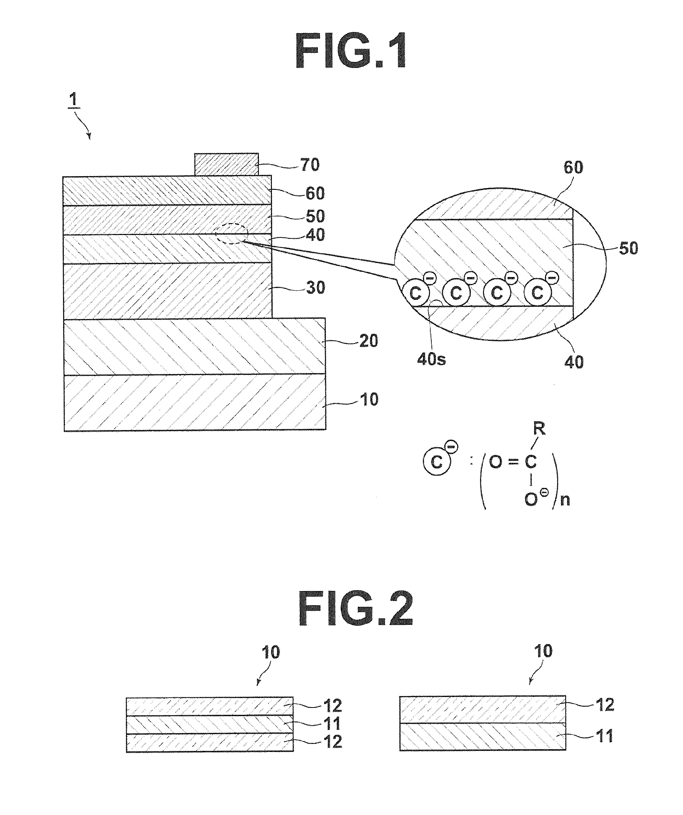

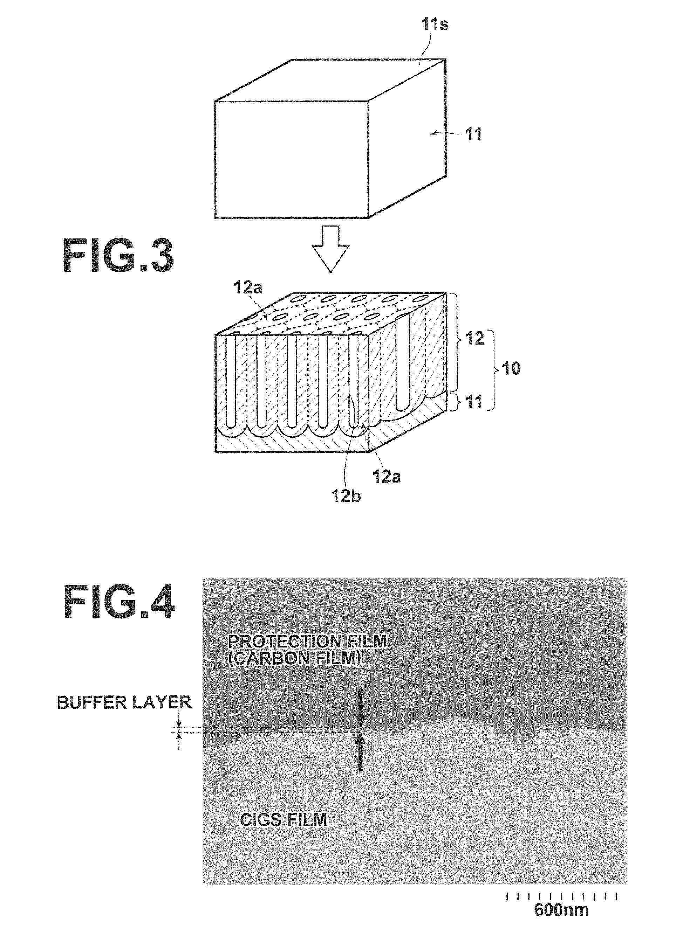

A structure of a photoelectric conversion device according to an embodiment of the present invention will now be described with reference to the accompanying drawings. Figure 1 is a schematic cross-sectional view of the photoelectric conversion device, Figure 2 schematically illustrates cross-sections of two substrates, illustrating the structures thereof, and Figure 3 is a perspective view illustrating a method of manufacturing an anodized substrate. In the drawings, each element is not necessarily drawn to scale for ease of visual recognition.

The photoelectric conversion device 1 is a device having substrate 10 on which the following are layered in the order listed below: a lower electrode (back contact electrode) 20; a photoelectric conversion semiconductor layer 30 which includes, as a major component, at least one kind of compound semiconductor having a chalcopyrite structure formed of a group Ib element, a group IIIb element, and a group VIb element; a buffer layer 40; a window layer 50; a transparent conductive layer (transparent electrode) 60; and an upper electrode (grid electrode) 70. The photoelectric conversion device 1 is characterized by the fact that the buffer layer 40 includes a ternary compound of a cadmium-free metal, oxygen, and sulfur, and a carbonyl ion is provided on a surface 40ₛ of the buffer layer 40 on the side of the transparent conductive layer 60. Figure 1 also shows an enlarged surface 40ₛ and schematically illustrates that carbonyl ions are present on the surface 40ₛ. A carbonyl ion is represented by an abbreviated form of C⁻ in the drawing. The window layer 50 may sometimes be omitted. Each component of the photoelectric conversion device 1 will be described hereinafter.

As for the substrate 10, as for the substrate there is not any specific restriction and the following may be cited by way of example: a glass substrate; a metal substrate, such as stainless steel substrate, on which an insulating layer is formed; an anodized substrate formed of an Al-based Al base with an Al₂O₃-based anodized film formed on at least one surface side; an anodized substrate formed of a composite base of a Fe-based Fe material and an Al-based Al material attached to at least one surface side of the Fe material with an Al₂O₃-based anodized film formed on at least one surface side of the composite base; an anodized substrate formed of a base of a Fe-based Fe member and an Al-based Al film formed on at least one surface side of the Fe material with an Al₂O₃-based anodized film formed on at least one surface side of the base; and a resin substrate, such as polyimide substrate.

Flexible substrates, such as a metal substrate on which an insulating film is formed, an anodized substrate, a resin substrate, and like, are preferably used as they can be manufactured by a roll-to-roll process (continuous process).

In view of the thermal expansion coefficient, heat resistance, and insulating property of the substrate, an anodized substrate selected from the group consisting of the following is particularly preferable: an anodized substrate formed of an Al-based Al base with an Al₂O₃-based anodized film formed on at least one surface side; an anodized substrate formed of a composite base of a Fe-based Fe material and an Al-based Al material attached to at least one surface side of the Fe material with an Al₂O₃-based anodized film formed on at least one surface side of the composite base; and an anodized substrate formed of a base of a Fe-based Fe material and an Al-based Al film formed on at least one surface side of the Fe material with an Al₂O₃-based anodized film formed on at least one surface side of the base.

Figure 2 schematically illustrates a substrate having an Al base 11 with an anodized film 12 formed on each side of the base 11 on the left and a substrate having an Al base 11 with an anodized film 12 formed on either one of the sides on the right. Anodized film 12 is an Al₂O₃-based film.

Preferably, substrate 10 is a substrate having an Al base 11 with an anodized film 12 formed on each side, as illustrated on the left in Figure 2 in order to prevent warpage of the substrate due to the difference in thermal expansion coefficient between Al and Al₂O₃ and detachment of the film due to the warpage during the device manufacturing process.

Anodization may be performed by dipping Al base 11, which is cleaned, smoothed by polishing, and the like, as required, as an anode together with a cathode in an electrolyte, and applying a voltage between the anode and cathode. As for the cathode, carbon, aluminum, or the like is used. There is not any specific restriction on the electrolyte and an acid electrolyte that includes one kind or two or more kinds of acids, such as sulfuric acid, phosphoric acid, chromic acid, oxalic acid, sulfamic acid, benzenesulfonic acid, amido-sulfonic acid, and the like, is preferably used.

There is not any specific restriction on the anodizing conditions, which are dependent on the electrolyte used. As for the anodizing conditions, for example, the following are appropriate: an electrolyte concentration of 1 to 80% by mass; a solution temperature of 5 to 70°C; a current density of 0.005 to 0.60 A/cm²; a voltage of 1 to 200V; and an electrolyzing time of 3 to 500 minutes.

As for the electrolyte, a sulfuric acid, a phosphoric acid, an oxalic acid, malonic acid, or a mixture thereof may preferably be used. When such electrolyte is used, the following conditions are preferable: an electrolyte concentration of 4 to 30% by mass, a solution temperature of 10 to 30°C, a current density of 0.05 to 0.30A/cm², and a voltage of 30 to 150V.

As shown in Figure 3, when Al-based Al base 11 is anodized, an oxidization reaction proceeds from a surface 11s in a direction substantially perpendicular to surface 11s, andAl₂O₃-based anodized film 12 is formed. Anodized film 12 generated by the anodization process has a structure in which multiple fine columnar bodies, each having a substantially regular hexagonal shape in a plan view, are tightly arranged. Each fine columnar body 12a has a fine pore 12b, substantially in the center, extending substantially linearly in a depth direction from surface 11s, and the bottom surface of each fine columnar body 12a has a rounded shape. Normally, a barrier layer without any fine pore 12b is formed at a bottom area of fine columnar bodies 12a. Anodized film 12 without any fine pore 12b may be formed if appropriate anodization conditions are employed.

There is not any specific restriction on the thicknesses of the Al base 11 and anodized film 12. In view of the mechanical strength of the substrate 10 and trend toward thinness and lightness of the device, the thickness of the Al base 11 prior to anodization is preferable to be, for example, 0.05 to 0.6mm, and more preferable to be 0.1 to 0.3mm. In view of the insulating property, mechanical strength, and trend toward thinness and lightness, the thickness of the anodized film 12 is preferable to be, for example, 0.1 to 100µm.

### (Lower Electrode)

There is not any specific restriction on the major component of the lower electrode (back contact electrode) 20 and Mo, Cr, W, or a combination thereof is preferably used, in which Mo is particularly preferable. There is not any specific restriction on the thickness of the lower electrode (back contact electrode) 20 and a thickness of 200 to 1000nm is preferable.

### (Photoelectric Conversion Layer)

There is not any specific restriction on the major component of the photoelectric conversion layer 30. Since high photoelectric conversion efficiency can be obtained, at least one kind of compound semiconductor having a chalcopyrite structure is preferable, and a semiconductor formed of a group Ib element, a group IIIb element, and a group VIb element is more preferable as the major component of the photoelectric conversion layer 30.

As for the major component of the photoelectric conversion layer 30, at least one kind of compound semiconductor formed of at least one kind of group Ib element selected from the group consisting of Cu and Ag, at least one kind of group IIIb element selected from the group consisting of Al, Ga, and In, and at least one kind of group VIb element selected from the group consisting of S, Se, and Te is preferably used.

As for the compound semiconductors described above, the following may be included: CuAlS₂, CuGaS₂, CuInS₂, CuAlSe₂, CuGaSe₂, AgAlS₂, AgGaS₂, AgInS₂, AgAlSe₂, AgGaSe₂, AgInSe₂, AgAlTe₂, AgGaTe₂, AgInTe₂, Cu(In, Al)Se₂, Cu(In, Ga) (S, Se)₂, Cu_{1-z}In₁₋ₓGaₓSe_{2-y}S_{y} (where, 0≤x≤1, 0≤y≤2, 0≤z≤1), (CI (G) S), Ag (In, Ga)Se₂, Ag (In, Ga) (S, Se)₂, and the like.

There is not any specific restriction on the film thickness of the photoelectric conversion layer 30, and a film thickness of 1.0 to 3.0µm is preferable and 1.5 to 2.0µm is more preferable.

### (Buffer Layer)

Buffer layer 40 is provided for (1) prevention of recombination of photogenerated carriers (2) band discontinuity alignment (3) lattice matching (4) coverage of surface unevenness of the photoelectric conversion layer, and the like.

In the present embodiment, the buffer layer 40 includes a ternary compound of a cadmium-free metal, oxygen, and sulfur, and a carbonyl ion is provided on a surface 40ₛ on the side of the transparent conductive layer 50.

There is not any specific restriction on the ternary compound of cadmium-free metal, oxygen, and sulfur, but a ternary compound of at least one kind of metal (which may include an unavoidable impurity) selected from the group consisting of Zn, In, and Sn, in addition to oxygen and sulfur, is preferable in view of the buffering function, and Zn (S, O)-based and/or Zn(S, O, OH)-based metal is more preferable.

Here, the representation of Zn(S, O) and Zn(S*,* 0, OH) refers to a mixed crystal of zinc sulfide and zinc oxide, and a mixed crystal of zinc sulfide, zinc oxide, and zinc hydroxide respectively. In this case, a part of the zinc sulfide, zinc oxide, or zinc hydroxide may be present in an amorphous state without forming the mixed crystal. The term "major component" as used herein refers to a component with a content of 80% by mass or more.

Further, the buffer layer 40 may be formed of only a Zn(S, O)-based and/or Zn(S, O, OH)-based Zn compound layer or a layered film of any other layer with a Zn (S, O)-based and/or Zn (S, O, OH)-based Zn compound layer.

In the present embodiment, carbonyl ions on the surface 40ₛ may be present in any fashion as long as they are present on the surface but it is preferable that they are adsorbed on the surface 40ₛ. In the case where the carbonyl ions are adsorbed on the surface 40ₛ, there is not any specific restriction on the adsorption aspect. If the charge state of the surface 40ₛ is positive, the carbonyl ions are adsorbed on the surface 40ₛ by the interaction between the surface 40ₛ and oxygen of the carbonyl ions. Such adsorption aspect is preferable, because in such adsorption aspect, the carbonyl ions are likely to be disposed densely on the surface 40ₛ and, therefore, the surface of the photoelectric conversion semiconductor layer 30, the under layer thereof, is likely to be uniformly covered, so that the compactness of the buffer layer 40 is increased. As for the carbonyl ion, there is not any specific restriction, but a carbonyl ion having a plurality of carbonyl groups is preferably used. This is considered to have been produced as a result that the growth of the buffer layer in the thickness direction is suppressed while the growth in the in-plane direction is promoted. An example of such carbonyl ion may be at least one kind of ion selected from a group consisting of citric acid ion, tartrate ion, and maleic acid ion. As being a trianion, the citric acid has three adsorbable sites, resulting in a dense and strong adsorption to the surface 40ₛ. Consequently, a compact film can be expected so that the citric acid is preferably used.

Likewise, in the case where many Zn²⁺ ions are present on the surface 40ₛ of the buffer layer, many adsorbable sites of carbonyl ions are present, so that the adsorption to the surface 40S is considered to become dense and strong, whereby a compact film is obtained.

Preferably, the buffer layer has a crystalline portion and an amorphous portion.

As described above, carbonyl ions are provided on the surface 40ₛ of the buffer layer 40 and it is likely that carbonyl ions are also taken into the inside of the buffer layer 40 in the deposition process.

There is not any specific restriction on the conductivity type of the buffer layer 40 and n-type or the like is preferable.

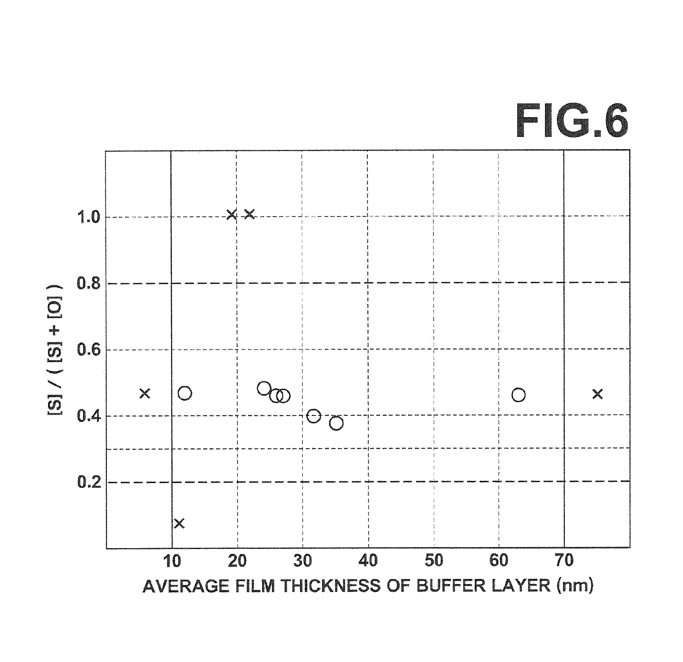

The present inventor has studied the film thickness of the aforementioned buffer layer in order to make the buffer layer not have any defect or gap which affects the photoelectric conversion efficiency. As a result of the study, the present inventor has found out that a buffer layer 40 that covers the photoelectric conversion layer 30 substantially uniformly and has fewer defects or gaps that adversely affect the photoelectric conversion efficiency may be realized by limiting the average film thickness of the buffer layer in the range of 10nm to 70nm, as shown in Examples and Comparative Example to be described later, thereby allowing a photoelectric conversion device 1 having high photoelectric conversion efficiency with favorable in-plane uniformity thereof to be provided (Table 2 and Figure 6).

Hereinafter, a method of manufacturing a buffer layer 40 of a Zn compound (which may includes an unavoidable impurity) consisting primarily of Zn(S, O)and/or Zn (S, O, OH) will be described.

The present inventor has found that, in a film forming process for forming a Zn compound layer consisting primarily of Zn(S, O) and/or Zn (S, O, OH) by a liquid phase method, a compact buffer layer having carbonyl ions on a surface thereof and well covering an under layer may be formed at a practical reaction speed by optimizing the composition and pH of the reaction solution and reaction temperature without essentially requiring a fine particle layer that functions as a nucleus, or a catalyst for crystal growth.

### <Fine Particle Layer Forming Process>

As described above, a fine particle layer forming process for forming a fine particle layer that functions as a nucleus or catalyst for crystal growth is not essentially required in the present embodiment. But a fine particle layer forming process may be included prior to the film forming process. In the case where the buffer layer manufacturing method of the present invention includes a fine particle layer forming process, the reaction speed in the film forming process may further be increased.

There is not any restriction on the composition of the fine particle layer but a semiconductor is preferable. As the layer to be formed in the subsequent process is a Zn system, a fine particle layer formed of a plurality of fine particles of one kind or two or more kinds consisting primarily of at least one kind selected from the group consisting of ZnS, Zn(S, O), and Zn(S, O, OH) is particularly preferable.

There is not any specific restriction on the method of forming the fine particle layer, and a method of applying a dispersion liquid that includes a plurality of fine particles or a method of depositing a plurality of fine particles by CBD (Chemical Bath Deposition) process is preferably used.

### <Film Forming Process>

There is not any specific restriction on the film forming method of a Zn compound layer consisting primarily of Zn (S, O)and/or Zn (S, O, OH) by liquid phase method, and the CBD process or the like is preferably used.

The "CBD process" as used herein refers to a process of depositing a crystal on a substrate at a moderate speed in a stable environment using, as the reaction solution, a metal ion solution having a concentration and a pH that induce supersaturation by the equilibrium represented by a general formula, [M(L)ᵢ]m⁺ ⇔ Mⁿ⁺+iL (where, M is a metal element, L is a ligand, and m, n, and i are positive numbers) and forming complexes of metal ion M.

Hereinafter, preferable compositions of the reaction solution will be described.

There is not any specific restriction on a component (Z) and it is preferable that the component (Z) includes at least one kind selected from the group consisting of zinc sulfate, zinc acetate, zinc nitrate, zinc citrate, and hydrates of these compounds. In the case where the zinc citrate is used as the component (Z), the zinc citrate serves also as the component (C).

There is not any specific restriction on the concentration of the component (Z) and is preferable to be 0.001 to 0.5M. There is not any specific restriction on a component (S) and is preferable to include thiourea. There is not any specific restriction on the concentration of the component (S) and is preferable to be 0.01 to 1.0M. The component (C) is a component that functions as a complex forming agent and the like, and complexes are formed easily by optimizing the kind and concentration of the component (C).

Each of Patent Documents 1 to 8 and Non-Patent Documents 3 and 4 cited under [BACKGROUND ART] and [PROBLEMS TO BE SOLVED BY THE INVENTION] do not use any citric acid compound. Non-Patent Documents 1 and 2 use sodium citrate but the layer formed by the CBD process is a ZnS layer, not a Zn compound layer consisting primarily of Zn (S, O) and/or Zn(S, O, OH). Non-Patent Documents 1 and 2 describe compositions of Zn and S in the ZnS thin films, in which S is included slightly more in comparison with the stoichiometric composition and a minute amount of oxygen that does not influence the composition ratio is included (Non-Patent Document 1: p. 922, right column, and p. 923, Table 1; Non-Patent Document 2: p.103, second paragraph in right column-p.104, left column).

Use of the component (C), which is at least one kind of citric acid compound, complexes are formed comparably or more easily than in the case where reaction solutions that do not use citric acid compounds described in Patent Documents 1 to 8 and Non-Patent Document 3 are used, without using an excessive amount of ammonia, and a crystal growth by CBD reaction is controlled favorably so that a film well covering the under layer may be formed stably. There is not any specific restriction on the component (C) and is preferable to include trisodium citrate and/or its hydrate.

The concentration of the sodium citrate in the reaction solution described in Non-Patent Document 1 is 0.3M. In the present invention, the concentration of the component (C) is set to a value of 0.001 to 0.25M. A concentration of the component (C) in the range described above allows complexes to be formed favorably so that a film well covering the under layer may be formed stably. A concentration of the component (C) exceeding 0.25M allows a stable water solution to be prepared with complexes being formed favorably but, on the other side of the coin, the progress of the deposition reaction on the substrate may be slowed or sometimes the reaction does not progress at all. Preferably, the concentration of the component (C) is 0.001 to 0.1M.

A component (N) is a component that functions as a pH conditioning agent but a component that also functions as a complex forming agent. There is not any specific restriction on ammonium salts favorably used as a component (N), and NH₄OH and the like may be cited by way of example.

The ammonium concentration described in Non-Patent Document 1 is 0.05 to 0.25M, and it is described that the optimum condition is 0.15M. In the present invention, the concentration of the component (N) is set to a value of 0.001 to 0.40M. By conditioning the pH with the component (N), the degrees of solubility and supersaturation of metal ions may be controlled. A concentration of the component (N) in the range of 0.001 to 0.40M allows the reaction to be fast and film forming to be performed at a practical production speed without the fine particle layer forming process prior to the film forming process. A concentration of the component (N) exceeding 0.40M causes the reaction to be slowed and a certain scheme is required, such as providing a fine particle layer prior to the film forming process. Preferably, the concentration of the component (N) is 0.01 to 0.30M.

The pH of the reaction solution prior to the start of reaction is set to a value of 9.0 to 12.0.

In the case where the pH of the reaction solution prior to the reaction is less than 9.0, the decomposition reaction of the component (S), such as the thiourea or the like, does not progress at all or may progress but very slowly, so that the deposition reaction does not progress. The decomposition reaction of thiourea is described, for example, in the Journal of the Electrochemical Society, 141, 205-210 (1994) and the Journal of Crystal Growth 299, 136-141(2007).

SC(NH₂) ₂ + OH⁻ ⇔ SH- + CH₂N₂+H₂O

SH⁻ + OH⁻ ⇔ S²⁻ + H₂O

A pH of the reaction solution exceeding 12.0 prior to the start of reaction causes the effect of the component (N), which also functions as a complex forming agent and the like, to make a stable solution to be increased so that the deposition reaction does not progress at all or may progress but very slowly. Preferably, the pH of the reaction solution prior to the start of reaction is 9.5 to 11.5.

In the reaction solution used in the present invention, the concentration of the component (N) is set to a value of 0.001 to 0.40M and such value of the concentration generally causes the pH of the reaction solution to fall within the range of 9.0 to 12.0 without requiring any particular pH conditioning, such as the use of a pH conditioning agent other than the component (N).

There is not any specific restriction on the pH of the solution after the reaction. Preferably, the pH of the solution after the reaction is 7.5 to 11.0. A pH of the solution less than 7.5 after the reaction implies that there has been a time period in which the reaction did not progress and senseless in view of efficient manufacturing. Further, such high pH drop in a system that includes ammonium having a buffering function implies that it is highly likely that the ammonium was excessively evaporated in the heating process and some improvement may be required in the manufacturing process. A pH of the reaction solution exceeding 11.0 after the reaction may have caused the decomposition of the thiourea to be facilitated but the deposition reaction to be significantly slowed because most of the zinc ions are stabilized as ammonium complexes. More preferably, the pH of the reaction solution after the reaction is 9.5 to 10.5.

In the reaction solution used in the present invention, the pH of the reaction solution after the reaction generally falls within the range of 7.5 to 11.0 without requiring any particular pH conditioning, such as the use of a pH conditioning agent other than the component (N).

The reaction temperature is set to a value of 70 to 95°C. A reaction temperature less than 70°C causes the reaction to be slowed and a thin film does not grow at all or may grow but it is difficult to obtain a desired thickness at a practical reaction speed. A reaction temperature exceeding 95°C causes more bubbles and the like to be generated in the reaction solution which may adhere to the film surface, thereby causing difficulties in growing a flat and homogeneous film. In the case where the reaction takes place in an open system, a reaction temperature exceeding 95°C causes a concentration change due to evaporation of the solvent and the like, thereby causing difficulties in maintaining a stable condition for the thin film deposition. Preferably, the reaction temperature is 80 to 90°C.

There is not any specific restriction on the reaction time. In the present invention, the reaction may take place at a practical reaction speed without a fine particle layer. The reaction time may dependent on the reaction temperature, but a layer well covering the under layer and having a sufficient thickness as the buffer layer may be formed by a reaction time of, for example, 10 to 60 minutes.

The reaction solution used in the present invention is an aqueous solution and the pH of the solution is not a highly acidic condition. Although the pH of the reaction solution may be 11.0 to 12.0, the reaction may take place under a moderate pH condition of less than 11.0. This allows the use of substrates that include a metal which is easily soluble in an alkaline solvent, such as a metal capable of forming a complex ion with a hydrogen ion, and a high density and uniform buffer layer may be formed without any possibility of damaging the substrates. Such substrates may include, for example, anodized substrates which can be used as flexible substrates, such as an anodized substrate formed of an Al-based Al base with an Al₂O₃-based anodized film formed on at least one surface side, an anodized substrate formed of a composite base of a Fe-based Fe material and an Al-based Al material attached to at least one surface side of the Fe material with an Al₂O₃-based anodized film formed on at least one surface side of the composite base, and an anodized substrate formed of a base of a Fe-based Fe material and an Al-based Al film formed on at least one surface side of the Fe material with an Al₂O₃-based anodized film formed on at least one surface side of the base, and the like.

Further, a high reaction temperature is not essential. Consequently, the reaction of the present invention is environmentally friendly, and the damage to the substrate is reduced to a minimum.

Further, after the film forming process, by annealing at least the buffer layer at a temperature lower than the upper limit temperature of the substrate, the conversion efficiency may be improved (Examples to be described later). The temperature of the annealing needs to be lower than the upper limit temperature of the substrate and the annealing is effective when the temperature is 150°C or higher. There is not any specific restriction on the annealing method and heating by a heater, heating in a drying machine, or optical annealing, such as laser annealing or flash lamp annealing, may be employed.

### (Window Layer)

The window layer 50 is an intermediate layer for introducing light. There is not any specific restriction on the composition of the window layer 50 and i-ZnO or the like is preferable. There is not any specific restriction on the film thickness of the window layer 50, in which 10nm to 2µm is preferable and 15 to 200nm is more preferable. The window layer 50 is not essential and some of the photoelectric conversion devices do not have the window layer 50.

### (Transparent Conductive Layer)

The transparent conductive layer (transparent electrode) 60 is a layer that functions as an electrode through which a current generated in photoelectric conversion layer 30 flows with the lower electrode 20 as a pair, as well as introducing light.

There is not any specific restriction on the composition of the transparent conductive layer 60, and n-ZnO, such as ZnO:Al or the like, is preferable. There is not any specific restriction on the film thickness of the transparent conductive layer 60, but 50nm to 2µm is preferable and 100nm to 1µm is more preferable.

There is not any specific restriction on the film forming method of the transparent conductive layer 60 and any gas phase method, such as sputtering and the like, or any liquid phase method may be used for forming the layer 60.

### (Upper Electrode)

There is not any specific restriction on the major component of the upper electrode (grid electrode) 70, and Al or the like is preferably used. There is not any specific restriction on the film thickness of the upper electrode 70, and 0.1 to 3µm is preferable.

The photoelectric conversion device 1 of the present embodiment is structured in the manner as described above.

The photoelectric conversion device 1 can be favorably used for solar cell applications and the like. It can be turned into a solar cell by attaching, as required, a cover glass, a protection film, and the like.

In the photoelectric conversion device 1, carbonyl ions are provided on a surface of the buffer layer 40 on the side of the transparent conductive layer 50 and the buffer layer is a thin film layer with an average film thickness of 10nm to 70nm and includes a ternary compound of a cadmium-free metal, oxygen, and sulfur. According to such arrangement, the compactness of the buffer layer 40 is increased by the presence of the carbonyl ions and the buffer layer becomes a layer uniformly covering the under layer (photoelectric conversion layer 30) without any defect or gap that affects the photoelectric conversion efficiency. Thus, according to the present, the photoelectric conversion device 1 may be a device having high photoelectric conversion efficiency with high in-plane uniformity thereof.

The buffer layer 40 described above may be formed under moderate alkaline conditions. This allows the use of a base material which includes a metal easily soluble in an alkaline solvent, such as aluminum, as the substrate 10. Therefore, an embodiment having a substrate 10 that includes a thin and highly flexible aluminum metal may provide a flexible photoelectric conversion device 1 having high photoelectric conversion efficiency with high in-plane uniformity thereof.

### (Design Changes)

The present invention is not limited to the embodiment described above, and design changes may be made as appropriate without departing from the sprit of the invention.

### [Examples]

Examples and Comparative Examples of the present invention will now be described. As Examples 1 to 7 and Comparative Examples 1 to 6, buffer layers were formed using different combinations of substrate, reaction solution used for forming buffer layers by CBD process, and CBD reaction condition, and the buffer layers so formed were evaluated. Hereinafter, substrates, preparation method of CBD reaction solutions, and reaction conditions used for Examples and Comparative Examples will be described first followed by the evaluation methods and results.

### <Substrates>

As for substrates, two types of substrates were provided.
(1) Cu(In_{0.7}Ga_{0.3})Se₂/Mo/SLG/AAO/Al/SUS substrate: substrate that uses an anodized substrate (30mm×30mm) made of a composite base of a 100 µm thick stainless steel (SUS) and a 30µm thick Al with an anodized aluminum film (AAO) formed on the surface of the Al, and a soda lime glass (SLG) layer, a Mo electrode layer, and a CIGS layer are further formed on the surface of the AAO on top of each other. The SLG layer and Mo lower electrode were formed by sputtering and a Cu(In_{0.7}Ga_{0.3})Se₂ layer was formed by three-stage process, one of multi-source deposition methods. The film thickness of each layer was as follows: SUS (greater than 100µm); Al (30µm); AAO (20 µm); SLG (0.2µm); Mo (0.8µm); and CIGS (1.8µm).
(2) Cu(In_{0.7}Ga_{0.3})Se₂Mo/SLG substrate: substrate having a soda lime glass (SLG) base with a Mo electrode layer on which a CIGS layer is formed. More specifically, a Mo lower electrode was formed on a 30mm×30mmsoda lime glass (SLG) base with a thickness of 0.8µm by sputtering. Then, a Cu(In_{0.7}Ga_{0.3})Se₂ layer was formed on the substrate with a thickness of 1.8µm by three-stage process, one of the multi-source deposition methods.

### <Surface Treatment of CIGS Layer>

A reaction vessel containing 10% aqueous solution of KCN was provided and the surface of the CIGS layer formed on the substrate was immersed in the vessel for three minutes at room temperature in order to remove impurities on the surface of the CIGS layer. After being taken out from the vessel, the substrate was sufficiently washed with water and subjected to a CBD process, to be described later, to form a buffer layer.

### <Preparation of CBD Reaction Solution>

(1) Reaction Solution 1: Examples 1 to 3, Example 6, Example 7, Comparative Example 4, and Comparative Example 5. An aqueous solution of zinc sulfate (0.18[M]) as an aqueous solution (I) of the component (Z), an aqueous solution of chiourea (0.30[M] of chiourea) as an aqueous solution (II) of the component (S), an aqueous solution of trisodium citrate (0.18[M]) as an aqueous solution (III) of the component (C), and aqueous ammonia (0.30[M]) as an aqueous solution (IV) of the component (N) were prepared respectively. Then, the solutions I, II, III were mixed in equal amounts to provide a mixed aqueous solution of 0.06[M] of zinc sulfate, 0.10[M] of chiourea, and 0.06[M] of trisodium citrate. Then the mixed aqueous solution so provided and the 0.30[M] of aqueous ammonia were mixed in equal amounts to obtain a reaction solution. When mixing the aqueous solutions (I) to (IV), the aqueous solution (IV) was added last. It is important to add the aqueous solution (IV) last in order to obtain a transparent reaction solution. The pH of the obtained reaction solution was 10.3.
(2) Reaction Solution 1: Example 4 and Example 5. An aqueous solution of zinc sulfate (0.18[M]) as an aqueous solution (I) of the component (Z), an aqueous solution of chiourea (1.50[M] of chiourea) as an aqueous solution (II) of the component (S), an aqueous solution of trisodium citrate (0.18 [M]) as an aqueous solution (III) of the component (C), and aqueous ammonia (0.30[M]) as an aqueous solution (IV) of the component (N) were prepared respectively. Then, the solutions I, II, III were mixed in equal amounts to provide a mixed aqueous solution of 0.06[M] of zinc sulfate, 0.50[M] of chiourea, and 0.06[M] of trisodium citrate. Then the mixed aqueous solution so provided and the 0.30 [M] of aqueous ammonia were mixed in equal amounts to obtain a reaction solution. When mixing the aqueous solutions (I) to (IV), the aqueous solution (IV) was added last. The pH of the obtained reaction solution was 10.2.
(3) Reaction Solution 3: Comparative Example 1 and Comparative Example 2. An aqueous solution of 0.077M of zinc chloride, 0.71M of thiourea, 1.39M of ammonia, and 2.29M of hydrazine was prepared, and a hydrochloric acid aqueous solution was added to provide a reaction solution with a pH of 10.3.
(4) Reaction Solution 4: Comparative Example 3. An aqueous solution of zinc sulfate (0.18[M]) as an aqueous solution (I) of the component (Z), an aqueous solution of chiourea (0.30[M] of chiourea) as an aqueous solution (II) of the component (S), an aqueous solution of trisodium citrate (0.18[M]) as an aqueous solution (III) of the component (C), and aqueous ammonia (2.4[M]) as an aqueous solution (IV) of the component (N) were prepared respectively. Then, the solutions I, II, III were mixed in equal amounts to provide a mixed aqueous solution of 0.06[M] of zinc sulfate, 0.10[M] of chiourea, and 0.06[M] of trisodium citrate. Then the mixed aqueous solution so provided and the 2.4[M] aqueous ammonia were mixed in equal amounts to obtain a reaction solution. When mixing the aqueous solutions (I) to (IV), the aqueous solution (IV) was added last. The pH of the obtained reaction solution was 11.4.

### <Buffer Layer Forming Process>

A buffer layer was formed on a substrate with a surface-treated CIGS layer such that only the surface of the CIGS layer is brought into contact with a CBD reaction solution (200ml in volume) . Here, a structurally devised CBD reaction vessel was used to allow a buffer layer to be formed only on the CIGS layer without the end and real faces of the substrate being directly touched to the reaction solution. More specifically, the reaction vessel used for containing a CBD reaction solution inside thereof has an opening on a wall (substantially perpendicular to the bottom surface thereof) which is smaller than the substrate (30mm×30mm), and the substrate was fixed from the outside of the reaction vessel so as to cover the entire opening to hold the reaction solution. Next, a predetermined CBD reaction solution was introduced therein and the entire CBD reaction vessel was set to a predetermined temperature to provide a water bath, whereby a portion of the surface of the CIGS layer facing the opening is immersed in the water bath and a buffer layer was deposited thereon.

Combinations of the substrate, CBD reaction solution, and reaction condition are shown in Table 1 and Table 2. After each reaction was completed, the substrate was taken out and the surface thereof is sufficiently washed with pure water, followed by drying at room temperature, whereby a buffer layer was formed.

### <Annealing>

Some samples of Examples and Comparative Examples were subjected to annealing in air at 200 °C for one hour. Whether or not the annealing is performed is indicated in Table 2.

### <Evaluation 1 (Evaluation of Film Thickness and Covering State of Buffer Layer)>

With respect to each of Examples and Comparative Examples, process steps until CBD (or until annealing for annealing samples) were performed and evaluation of film thickness and covering state was performed for each thin film whose outermost surface is a buffer layer. The evaluation was performed using a scanning electron microscope (SEM).

In order to evaluate the covering state of the buffer layer over the CIGS layer, the surface of the buffer layer was observed first by the SEM. Then, after a protection layer was formed on the buffer layer surface, focused ion beam (FIB) processing was performed to cut a cross-section of the buffer layer and a SEM observation was performed on the cross-section. The film thickness evaluation was also performed from the SEM image of the cross-section. This evaluation has demonstrated that the buffer layers of Examples 1 to 7 and Comparative Examples 3 and 5 favorably cover the surfaces of the CIGS layers. A SEM photograph of the cross-section of Example 2 is shown in Figure 4.

### <Evaluation 2 (Evaluation of Surface State of Buffer layer)>

With respect to each of Examples and Comparative Examples, process steps until CBD (or until annealing for annealing samples) were performed and evaluation of surface state (surface substance identification) was performed for each thin film whose outermost surface is a buffer layer by infrared spectroscopic analysis (IR). For the thin film of each Example and Comparative Example, the evaluation was performed by attenuated total reflection method (ATR method).

At that time, standard substances that may possibly be included in the raw material and end product were also measured by KBr disk method and used for identifying surface substance present on the buffer layer surface.

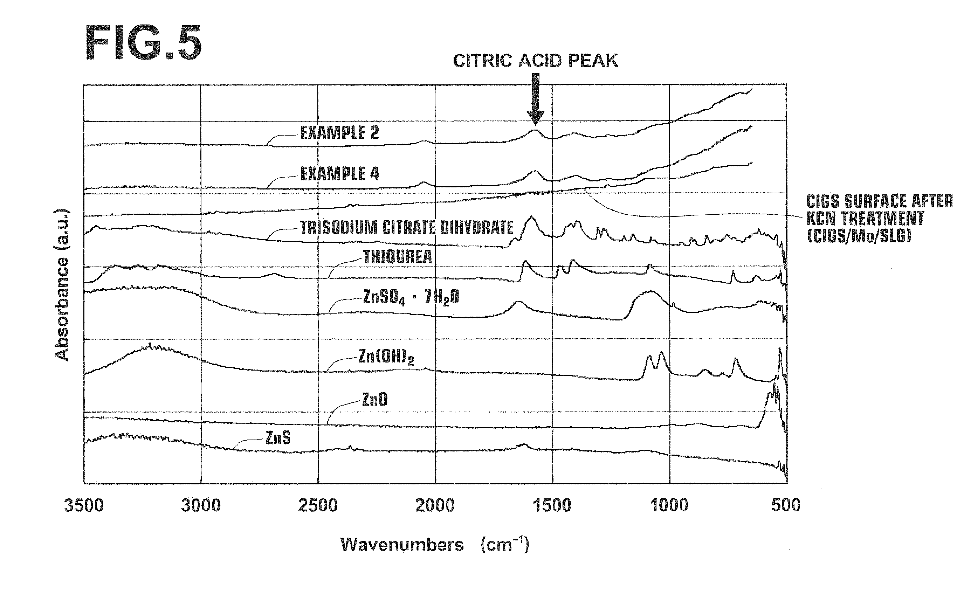

An IR spectrum measurement was performed on the buffer layer surface of each of Examples and Comparative Examples to identify the surface substance. A FT-IR (Fourier transform infrared spectrophotometer) available from Varian Technologies Japan Ltd. was used for the measurement. The results are shown in Figure 5.

Figure 5 also shows IR spectra of raw powder of trisodium citrate dihydrate (product of Wako Pure Chemical Industries, Ltd.), raw powder of thiourea (product of Wako Pure Chemical Industries, Ltd.), zinc sulfate heptahydrate (product of Kanto Chemical Industry Co., Ltd.), Zn(OH)₂ particle (synthetic), ZnO particle (product of Japan Pure Chemical Co., Ltd.), and ZnS particle (product of Kanto Chemical Industry Co., Ltd.) measured by KBr disk method. As shown in the graph, while a citric acid peak was detected (position indicated by the arrow in the graph) from each of samples of Examples 2 and 4, a trisodium citrate peak was not detected from the sample without a buffer layer.

Although, a thiourea peak is also present at the position indicated by the arrow in the graph, it is thought that the thiourea is a highly water-soluble compound and it is dissolved in water and washed away during a washing process in the water-based film forming as in the present embodiment. Thus, it was confirmed from Figure 5 that citric acid ions are present on the surface of the buffer layer.

Likewise, a citric acid peak was detected also from each Example not shown in Figure 5. In the mean time, citric acid peaks were not detected from Comparative Examples 1 and 2.

### <Evaluation 3 (Evaluation of Buffer Layer Composition)>

With respect to each of Examples and Comparative Examples, process steps until CBD (or until annealing for annealing samples) were performed and composition analysis was performed in the depth direction for each thin film whose outermost surface is a buffer layer by X-ray photoelectron spectroscopy (XPS).

The etching for the XPS measurement was performed using Ar ions. The results obtained are summarized in Table 2. Table 2 also shows the depth of each exposed surface by the etching from the surface prior to the etching.

As analysis results, not only Zn and S but also O was detected in the buffer layers corresponding to Examples 1 to 7 and Comparative Examples 3 to 5. In the buffer layers corresponding to Comparative Examples 1 and 2, however, only Zn and S were detected.

### <Evaluation of Photoelectric Conversion Efficiency>

An Al-doped conductive zinc oxide thin film was formed on the buffer layer of each of Examples and Comparative Examples with a thickness of 300nm by sputtering. Then, an Al electrode was formed by vapor deposition as the upper electrode to produce a photoelectric conversion device (single solar cell with a light receiving area of 0.516cm²). Eight cells were produced and evaluated with respect to each of Examples and Comparative Examples.

A current-voltage characteristic evaluation was performed for the obtained photoelectric conversion devices (eight cells for each of examples and Comparative Examples) by measuring energy conversion efficiency using a solar simulator under the condition in which pseudo sunlight of Air Mass (AM) = 1.5, 100mW/cm² was used. The measurement was performed after illuminating the light for 30 minutes.

Results obtained are summarized in Table 2. In Table 2, the coatability evaluation represents observation results of sample pieces obtained by FIB processing the cross-sections of the samples with a field emission scanning electron microscope (FESEM) and counting the number of uncoated areas in a width direction of 100µm in which the circle "○" indicates that the number of uncoated areas is two or less and the triangle "Δ" indicates that the number of uncoated areas is less than ten. Further, each of energy conversion efficiency in Table 2 represents an average value of eight cells with a value of standard deviation of eight cells.

With respect to the results of Examples and Comparative Examples, Figure 6 illustrates the relationship between the molar ratio of sulfur atoms with respect to the total number of moles of sulfur atoms and oxygen atoms in the buffer layer, average film thickness of the buffer layer, and characteristics of the obtained photoelectric conversion device (photoelectric conversion device and in-plane uniformity). In Figure 6, a circle mark "○" indicates a photoelectric conversion device having a buffer layer with good coatability and achieving photoelectric conversion efficiency of not less than 8.0 percent with an in-plane standard deviation of not greater than 2% and a cross mark "×" indicates a photoelectric conversion device not achieving those values described above. A sample having a standard deviation greater than 2% is indicated by "×" even though it has photoelectric conversion efficiency of not less than 8%, since such a sample did not show a conversion efficiency of not less than 8% with good reproducibility.

The effectiveness of the photoelectric conversion device of the present invention has been confirmed from Table 2 and Figure 6.

**Table 1**

| | Example 1 | Example 2 | Example 3 | Example 4 | Example 5 | Example 6 | Example 7 | Comp.Exam. 1 | Comp.Exam. 2 | Comp.Exam. 3 | Comp.Exam. 4 | Comp.Exam.5 | Comp.Exam. 6 |
|---|---|---|---|---|---|---|---|---|---|---|---|---|---|
| Zinc Sulfide [M] | 0.03 | 0.03 | 0.03 | 0.03 | 0.03 | 0.03 | 0.03 | - | - | 0.03 | 0.03 | 0.03 | - |
| Zinc Chloride | - | - | - | - | - | - | - | *Note 1 | *Note 1 | - | - | - | - |
| Thiourea [M] | 0.05 | 0.05 | 0.05 | 0.25 | 0.25 | 0.05 | 0.05 | *Note 1 | *Note 1 | 0.05 | 0.05 | 0.05 | - |
| Trisodium Citrate [M] | 0.03 | 0.03 | 0.03 | 0.03 | 0.03 | 0.03 | 0.03 | - | - | 0.03 | 0.03 | 0.03 | - |
| Hydrazine [M] | - | - | - | - | - | - | - | *Note 1 | *Note 1 | - | - | - | - |
| Ammonia [M] | 0.15 | 0.15 | 0.15 | 0.15 | 0.15 | 0.15 | 0.15 | *Note 1 | *Note 1 | 1.20 | 0.15 | 0.15 | - |
| Reaction Temperature | 90°C | 90°C | 90°C | 90°C | 90°C | 90°C | 90°C | 90°C | 90°C | 90°C | 90°C | 90°c | - |
| Reaction Time | 30min | 30min | 30min | 45min | 45min | 15min | 60min | 60min | 60min | 45min | 5min | 90min | - |
| Agitation | NO | NO | NO | NO | NO | NO | NO | NO | NO | NO | NO | NO | - |

| | | | | | | | | | | | | | |
|---|---|---|---|---|---|---|---|---|---|---|---|---|---|
| *Note 1:Described in Specification | | | | | | | | | | | | | |

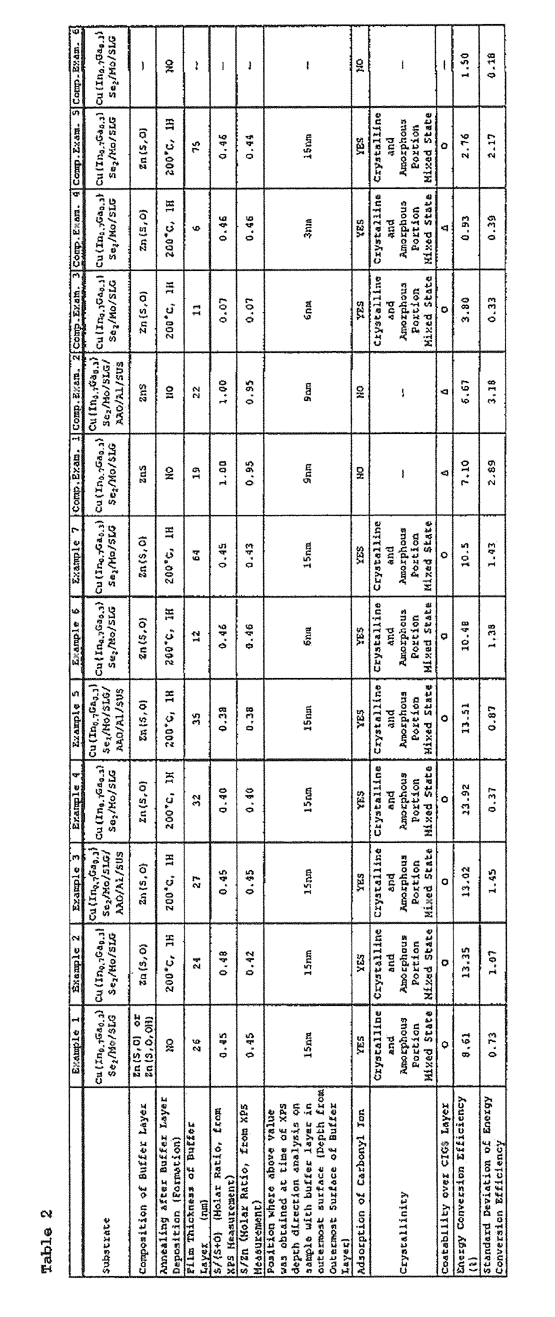

The buffer layer of the present invention and the manufacturing method thereof are applicable to photoelectric conversion devices used for solar cells, infrared sensors, and the like.

## Claims

1. A photoelectric conversion device, comprising a substrate on which the following are layered in the order listed below: a lower electrode layer; a photoelectric conversion semiconductor layer which includes, as a major component, at least one kind of compound semiconductor having a chalcopyrite structure formed of a group Ib element, a group IIIb element, and a group VIb element; a buffer layer; and a transparent conductive layer, wherein:
a carbonyl ion is provided on a surface of the buffer layer on the side of the transparent conductive layer; and
the buffer layer is a thin film layer having an average film thickness of 10nm to 70nm and includes a ternary compound of a cadmium-free metal, oxygen, and sulfur.

2. The photoelectric conversion device of claim 1, wherein the carbonyl ion has a plurality of carbonyl groups.

3. The photoelectric conversion device of claim 1 or 2, wherein the carbonyl ion is a citrate ion.

4. The photoelectric conversion device of any of claims 1 to 3, wherein the carbonyl ion is adsorbed on the surface.

5. The photoelectric conversion device of any of claims 1 to 4, wherein the buffer layer includes a crystalline portion and an amorphous portion.

6. The photoelectric conversion device of any of claims 1 to 5, wherein a molar ratio of sulfur atoms to a total number of moles of the sulfur atoms and oxygen atoms in the buffer layer is 0.3 to 0.6.

7. The photoelectric conversion device of any of claims 1 to 6, wherein the cadmium-free metal is at least one kind of metal (which may include an unavoidable impurity) selected from the group consisting of Zn, In, and Sn.

8. The photoelectric conversion device of claim 7, wherein the cadmium-free metal is Zn.

9. The photoelectric conversion device of any of claims 1 to 8, wherein the substrate includes a metal capable of forming a complex ion with a hydroxide ion.

10. The photoelectric conversion device of claim 9, wherein the substrate is an anodized substrate selected from the group consisting of:
an anodized substrate formed of an Al-based Al base with an Al₂O₃-based anodized film formed on at least one surface side;
an anodized substrate formed of a composite base of a Fe-based Fe material and an Al-based Al material attached to at least one surface side of the Fe material with an Al₂O₃-based anodized film formed on at least one surface side of the composite base; and
an anodized substrate formed of a base of a Fe-based Fe material and an Al-based Al film formed on at least one surface side of the Fe material with an Al₂O₃-based anodized film formed on at least one surface side of the base.

11. The photoelectric conversion device of any of claims 1 to 10, wherein the major component of the photoelectric conversion semiconductor layer is at least one kind of compound semiconductor, comprising:
at least one kind of group Ib element selected from the group consisting of Cu and Ag;
at least one kind of group IIIb element selected from the group consisting of Al, Ga, and In; and
at least one kind of group VIb element selected from the group consisting of S, Se, and Te.

12. A solar cell, comprising the photoelectric conversion device of any of claims 1 to 11.
